Europäisches Patentamt

European Patent Office

Office européen des brevets

(11) Publication number: **0 530 729 A1**

# EUROPEAN PATENT APPLICATION

(21) Application number: **92114859.9**

(22) Date of filing: **31.08.92**

(51) Int. Cl.⁵: **H01L 21/302**, C09J 7/02, C09J 133/06

(30) Priority: **02.09.91 JP 220863/91**

(43) Date of publication of application:
**10.03.93 Bulletin 93/10**

(84) Designated Contracting States:
**DE FR GB IT NL**

(71) Applicant: **MITSUI TOATSU CHEMICALS, Inc.**
**2-5 Kasumigaseki 3-chome**
**Chiyoda-Ku Tokyo 100(JP)**

(72) Inventor: **Narimatsu, Osamu**
**2-1-1, Sotoyama, Minami-ku**
**Nagoya-shi, Aichi-ken(JP)**
Inventor: **Komatsu, Kazuyoshi**
**73-1, Sunaguchicho, Minami-ku**
**Nagoya-shi, Aichi-ken(JP)**
Inventor: **Takemura, Yasuo**
**E-43, Takaiharuryo, 5, Takiharucho,**
**Minami-ku**
**Nagoya-shi, Aichi-ken(JP)**
Inventor: **Takeuchi, Yoko**
**5-42, Kamiiida Higashimachi, Kita-ku**
**Nagoya-shi, Aichi-ken(JP)**

(74) Representative: **Strehl, Schübel-Hopf,**
**Groening**
**Maximilianstrasse 54 Postfach 22 14 55**
**W-8000 München 22 (DE)**

(54) **Method for grinding back side of semiconductor wafer and pressure-sensitive adhesive tape used in said method.**

(57) According to the present invention, there are provided (a) a method for grinding the back side of a semiconductor wafer, which comprises attaching a pressure-sensitive adhesive tape to the front side of the semiconductor wafer on which an integrated circuit has been formed and then grinding the back side of the semiconductor wafer, said pressure-sensitive adhesive tape comprising a base film and a pressure-sensitive adhesive layer formed thereon, having an adhesion strength to mirror wafer, of 50-450 g/25 mm at 23°C, said pressure-sensitive adhesive tape being obtained by coating to one side of said base film, an aqueous acrylic resin emulsion type pressure-sensitive adhesive mixture comprising 100 parts by weight (as solid content) of an aqueous acrylic resin emulsion type pressure-sensitive adhesive, 0.05-10 parts by weight of a non-ionic surfactant, 0.01-10 parts by weight of a crosslinking agent selected from the group consisting of an epoxy type crosslinking agent, an aziridine type crosslinking agent and a mixture of the above two and 0.1-100 parts by weight of a water-soluble organic compound having a boiling point of 100°C or higher, and then drying the coated pressure-sensitive adhesive mixture on said side of said base film, and (b) a pressure-sensitive adhesive tape used in said method.

The pressure-sensitive adhesive tape of the present invention has a low initial adhesion strength to mirror wafer and shows a small increase in adhesion strength with time. Consequently, the tape gives rise to no breakage of semiconductor wafer in peeling off the tape from the front side of the semiconductor wafer and promises good peelability.

EP 0 530 729 A1

## Background of the Invention

### a) Field of the Invention

The present invention relates to a method used, in production of semiconductor integrated circuit (hereinafter referred to as semiconductor IC) chip, for grinding of the side of a semiconductor wafer in which no integrated circuit has been formed (said side is hereinafter referred to as back side of semiconductor wafer), which method comprises attaching a pressure-sensitive adhesive tape to the side of said semiconductor wafer in which an integrated circuit has been formed (said side is hereinafter referred to as front side of semiconductor wafer) and then grinding the back side of said wafer, as well as to a pressure-sensitive adhesive tape used in said method.

### b) Description of the Related Art

Semiconductor IC chips are generally produced by slicing a single crystal of high-purity silicon or the like to obtain a semiconductor mirror wafer, forming an integrated circuit in one side of the wafer by means of thermal diffusion of impurity, ultrafine processing or the like, grinding the back side of the resulting semiconductor wafer to make it thinner, and dicing the ground semiconductor wafer to obtain a semiconductor IC chip.

In grinding the back side of a semiconductor wafer, there has been adopted a method of attaching a pressure-sensitive adhesive tape to the front side of the semiconductor wafer in order to prevent, for example, (1) cracking of semiconductor wafer per se caused by grinding stress and (2) damaging of integrated circuit formed on the front side of semiconductor wafer (said cracking and damaging are hereinafter referred to as breakage of semiconductor wafer).

As the pressure-sensitive adhesive tape, there is disclosed in, for example, Japanese Patent Publication No. 51511/1989, a film for semiconductor IC processing which is obtained by coating, on at least one side of a synthetic resin film, an aqueous emulsion type pressure-sensitive adhesive containing a non-ionic surfactant or its mixture with a water-soluble organic compound having a boiling point of 100°C or higher.

The above film for semiconductor processing is useful in that the pressure-sensitive adhesive, dust, etc. which may remain or be present on the front side of a semiconductor wafer after the back side of the wafer has been ground and then said film has been peeled off from the front side of the wafer, can be easily removed by water washing or the like; however, the film shows an increase of adhesion strength with time and has a problem in peelability. Thus, the film is not fully satisfactory.

The time required from attachment of pressure-sensitive adhesive tape to front side of semiconductor wafer and subsequent grinding of back side of said semiconductor wafer, to peeling of said tape, had been not more than one day. Recently, however, the time has become more than one day, in many cases, because of increase in amount of semiconductor wafers produced, increase in holidays, etc. This has created a problem of difficult peeling when there is used a pressure-sensitive adhesive tape having a pressure-sensitive adhesive layer whose adhesion strength increases with time.

When a pressure-sensitive adhesive tape having a pressure-sensitive adhesive layer whose adhesion strength increases with time is applied to the front side of a semiconductor wafer, the back side of the semiconductor wafer is ground, then the tape-attached wafer is allowed to stand for a long time, for example, more than one day, the adhesion strength of the tape to the front side of the wafer increases; as a result, the peeling of the tape from the wafer becomes difficult and breaks the semiconductor wafer. This problems occurs actually. The same problem (difficult peeling and wafer breakage) occurs even with a pressure-sensitive adhesive tape which shows no increase in adhesion strength with time but has a high initial adhesion strength.

In order to obtain a pressure-sensitive adhesive having a high cohesive strength, for example, Japanese Patent Application Kokai (Laid-Open) No. 32873/1985 discloses a pressure-sensitive adhesive composition comprising 100 parts by weight (as solid content) of an acrylic emulsion type pressure-sensitive adhesive having a crosslinkable functional group and, as a crosslinking agent, 0.1-10 parts by weight of a melamine resin and 0.001-5 parts by weight of an aziridinyl compound. This pressure-sensitive adhesive composition is well balanced in cohesive strength and adhesion strength and provides a pressure-sensitive adhesive layer having excellent temperature sensitivity at both low temperatures and high temperatures.

However, the above pressure-sensitive adhesive composition has a high adhesion strength to SUS-304 (AISI type 304 stainless steel) plate, of 570-700 g/20 mm at 23°C.

When a pressure-sensitive adhesive tape having such a high adhesion strength is attached to the front side of a semiconductor wafer, the back side of the semiconductor wafer is ground, then the pressure-

2

sensitive adhesive tape is peeled off from the front side of the semiconductor wafer, the wafer is broken in some cases. Therefore, the pressure-sensitive adhesive composition mentioned in the above document cannot be used as an adhesive for production of a pressure-sensitive adhesive tape used in grinding of a semiconductor wafer.

According to the finding by the present inventors, the above pressure-sensitive adhesive composition further has the problem that the increase of adhesion strength with time after application to adherend is large although the temperature dependency of adhesion strength is small and good.

Japanese Patent Application Kokai (Laid-Open) No. 211387/1986 discloses a repeelable pressure-sensitive adhesive comprising

(A) 100 parts by weight of an emulsion comprising

    (1) 100 parts by weight of a vinyl copolymer consisting of

        (a) 0.5-10% by weight of an unsaturated acid monomer unit,

        (b) 0.5-10% by weight of a hydroxyl group-containing unsaturated monomer unit, and

        (c) the remainder of an unsaturated monomer unit copolymerizable with (a) and (b), and

    (2) 0.2-10 parts by weight of an epoxy resin, and

(B) 0.2-5 parts by weight of an alkali metal compound.

The above repeelable pressure-sensitive adhesive, however, has a high adhesion strength to SUS (stainless steel) plate, of 700-900 g/25 mm at 20°C and may break a semiconductor wafer when said adhesive attached to the front side of the semiconductor wafer is peeled off. Thus, the repeelable pressure-sensitive adhesive cannot be used as an adhesive for production of a pressure-sensitive adhesive tape used in grinding of a semiconductor wafer.

## Summary of the Invention

The objects of the present invention are to solve the above-mentioned problems of the prior art and provide firstly a pressure-sensitive adhesive tape used in grinding the backside of a semiconductor wafer, having a pressure-sensitive adhesive layer having a small initial adhesion strength and showing no adhesion strength increase with time when, after application, allowed to stand for a long time and secondly a method for grinding the back side of a semicondcutor wafer, which comprises attaching the above pressure-sensitive adhesive tape to the front side of said semiconductor wafer and then conducting said grinding.

The present inventors made studies and found that the optimum adhesion strength to be possessed by a pressure-sensitive adhesive tape used in grinding the back side of a semiconductor wafer is 50-450 g/25 mm in terms of an adhesion strength to a mirror wafer on which no integrated circuit has been formed, although the optimum adhesion strength varies depending upon the surface condition of the mirror wafer.

That is, the present inventors found that when the adhesion strength of a pressure-sensitive adhesive tape right after attachment to the front side of a semiconductor wafer is less than 50 g/25 mm, the tape is peeled while the back side of the semiconductor wafer is ground; therefore, the tape is unable to exhibit a protective function and the semiconductor wafer is broken. When the adhesion strength is more than 450 g/25 mm, the tape has low peelability; peeling is difficult; forced peeling incurs breakage of semiconductor wafer.

The present inventors made studies also on a pressure-sensitive adhesive composition which can maintain its adhesion strength in the range of 50-450 g/25 mm when attached to a mirror wafer and allowed to stand for at least five days, preferably ten days. As a result, it was found that an aqueous acrylic resin emulsion type pressure-sensitive adhesive containing a non-ionic surfactant, a particular water-soluble organic compound and a particular crosslinking agent has a low initial adhesion strength and shows no increase in adhesion strength with time. The finding has led to the completion of the present invention.

According to the first aspect of the present invention, there is provided a method for grinding the back side of a semiconductor wafer, which comprises attaching a pressure-sensitive adhesive tape to the front side of the semiconductor wafer on which an integrated circuit has been formed and then grinding the back side of the semiconductor wafer, said pressure-sensitive adhesive tape comprising a single-layered or multi-layered synthetic resin film as a base film and a pressure-sensitive adhesive layer formed thereon, having an adhesion strength to mirror wafer, of 50-450 g/25 mm at 23°C, said pressure-sensitive adhesive tape being obtained by coating to one side of said base film, an aqueous acrylic resin emulsion type pressure-sensitive adhesive mixture comprising 100 parts by weight (as solid content) of an aqueous acrylic resin emulsion type pressure-sensitive adhesive, 0.05-10 parts by weight of a non-ionic surfactant, 0.01-10 parts by weight of a crosslinking agent selected from the group consisting of an epoxy type crosslinking agent, an aziridine type crosslinking agent and a mixture of the above two and 0.1-100 parts by weight of a water-soluble organic compound having a boiling point of 100°C or higher, and then drying the coated pressure-sensitive adhesive mixture on said side of said base film.

According to the present invention, there is further provided a pressure-sensitive adhesive tape used in grinding the back side of a semiconductor wafer, which comprises a single-layered or multi-layered synthetic resin film as a base film and a pressure-sensitive adhesive layer formed thereon, having an adhesion strength to mirror wafer, of 50-450 g/25 mm at 23°C, and which is obtained by coating to one side of said base film, an aqueous acrylic resin emulsion type pressure-sensitive adhesive mixture comprising 100 parts by weight (as solid content) of an aqueous acrylic resin emulsion type pressure-sensitive adhesive, 0.05-10 parts by weight of a non-ionic surfactant, 0.01-10 parts by weight of a crosslinking agent selected from the group consisting of an epoxy type crosslinking agent, an aziridine type crosslinking agent and a mixture of the above two and 0.1-100 parts by weight of a water-soluble organic compound having a boiling point of 100°C or higher, and then drying the coated pressure-sensitive adhesive mixture on said side of said base film.

Detailed Description of the Invention

In the present invention, adhesion strength to mirror wafer at 23°C is a value obtained by measurement in accordance with the following method.

A sample tape of 25 mm in width is attached to the surface of a silicon mirror wafer using a rubber roller of 2 kg/cm$^2$. The tape-attached wafer is allowed to stand in an atmosphere of 23°C (temperature) and 50% (relative humidity) for a given length of time. Then, the sample tape is peeled off from the surface of the silicon mirror wafer using a TENSILON type tensile tester produced by Toyo Baldwin Co., Ltd., under the conditions of 23°C (temperature), 180° (peeling angle) and 30 cm/min (peeling speed), and the adhesion strength shown in this peeling is measured.

Description is first made on the pressure-sensitive adhesive tape of the present invention used in grinding of the back side of a semiconductor wafer.

The present pressure-sensitive adhesive tape used in grinding of the back side of a semiconductor wafer is produced by coating to one side of a single-layered or multi-layered synthetic resin film as a base film, an aqueous acrylic resin emulsion type pressure-sensitive adhesive mixture comprising a particular amount of an aqueous acrylic resin emulsion type pressure-sensitive adhesive, a particular amount of a non-ionic surfactant, a particular amount of a crosslinking agent selected from the group consisting of an epoxy type crosslinking agent, an aziridine type crosslinking agent and a mixture of the above two, and a particular amount of a water-soluble organic compound having a boiling point of 100°C or higher, and then conducting drying to form a pressure-sensitive adhesive layer of particular composition on one side of said base film.

Ordinarily, the thus-produced pressure-sensitive adhesive tape used in grinding the back side of a semiconductor wafer is stored or transported after attaching, as a release film, a polypropylene film or the like onto the pressure-sensitive adhesive layer of the tape and then making the resulting material into a roll or cutting the resulting material into pieces of desired shape and making them into a laminate, or after cutting the above-produced tape into a desired shape, attaching the cut tape to a polypropylene film or the like and making the resulting material into a roll.

As the base film used in the present invention, there can be mentioned a single-layered or multi-layered synthetic resin film of 5-500 $\mu$m in thickness, consisting of an ethylene-vinyl acetate copolymer (hereinafter referred to as EVA), a polybutadiene (hereinafter referred to as PB), a polyethylene, a polypropylene (hereinafter referred to as PP), a polyamide, a polyethylene terephthalate or the like.

Among the above base films, a base film having a Shore D hardness of 40 or less is preferred in order for the film to be able to absorb the stress applied in grinding the back side of a semiconductor wafer and prevent the breakage of the semiconductor wafer. When the base film is multi-layered, the layer(s) close to the pressure-sensitive adhesive layer preferably has (have) a Shore D hardness of 40 or less.

It is also preferable that the side of the base film on which a pressure-sensitive adhesive mixture is to be coated, be subjected beforehand to a corona discharge treatment or the like, in order for said adhesive mixture to have improved coatability on said base film.

The aqueous acrylic resin emulsion type pressure-sensitive adhesive used in the present invention is obtained by emulsion-polymerizing a monomer mixture comprising an alkyl (meth)acrylate monomer and a carboxyl group-containing monomer, in a deionized water medium containing an emulsifier, a polymerization initiator, etc. The monomer mixture may further comprise a vinyl monomer and the like each copolymerizable with the above-mentioned monomers. The selection of monomer types and amounts can be appropriately made depending upon the adhesion strength required for the pressure-sensitive adhesive layer to be formed.

The thus-obtained aqueous acrylic resin emulsion type pressure-sensitive adhesive generally has a solid content (an acrylic resin) of 30-60% by weight. The adhesive may be diluted with water for viscosity adjustment, prior to its coating on a base film.

As the alkyl (meth)acrylate monomer, there can be mentioned, for example, methyl acrylate, methyl methacrylate, ethyl acrylate, ethyl methacrylate, propyl acrylate, propyl methacrylate, butyl acrylate, butyl methacrylate, hexyl acrylate, hexyl methacrylate, octyl acrylate, octyl methacrylate, nonyl acrylate, nonyl methacrylate, dodecyl acrylate and dodecyl methacrylate. The alkyl group in the monomer may be a straight chain or a branched chain. The above monomers may be used in combination of two or more, depending upon the requirement.

As the carboxyl group-containing monomer, there can be mentioned, for example, acrylic acid, methacrylic acid, crotonic acid, itaconic acid, maleic acid and fumaric acid.

The amount of the carboxyl group-containing monomer is preferably 0.1-10 parts by weight per 100 parts by weight of the monomer mixture. The carboxyl group reacts with a crosslinking agent (described later) to form a crosslinked structure; hence, when the amount of the carboxyl group-containing monomer is less than 0.1 part by weight, no sufficient crosslinked structure is formed, resulting in low cohesive strength and making it impossible to achieve reduction in initial adhesion strength and prevention of increase in adhesion strength with time.

Meanwhile, when the amount of the carboxyl group-containing monomer is more than 10 parts by weight, the emulsion polymerization system is unstable, making it difficult to obtain a stable emulsion.

As the vinyl monomer copolymerizable with the alkyl (meth)acrylate monomer and the carboxyl group-containing monomer, there can be mentioned, for example, hydroxyethyl acrylate, hydroxyethyl methacrylate, hydroxypropyl acrylate, hydroxypropyl methacrylate, acrylamide, methacrylamide, dimethylaminoalkylacrylate, dimethylaminoalkylmethacrylate, vinyl acetate, styrene and acrylonitrile.

The addition to the aqueous acrylic resin emulsion type pressure-sensitive adhesive, of a crosslinking agent, a non-ionic surfactant and a water-soluble organic compound having a boiling point of 100°C or higher is conducted ordinarily after production of the adhesive or before coating of the resulting adhesive mixture on a base film. However, the addition of the non-ionic surfactant may be conducted together with the addition of an emulsifier to the monomer mixture prior to the emulsion polymerization of the mixture.

Examples of the non-ionic surfactant used in the present invention are polyoxyethylene alkyl ethers such as polyoxyethylene lauryl ether, polyoxyethylene stearyl ether and the like; polyoxyethylene alkyl esters such as polyoxyethylene lauryl ester, polyoxyethylene stearyl ester and the like; polyoxyethylene alkyl phenyl ethers such as polyoxyethylene octyl phenyl ether, polyoxyethylene nonyl phenyl ether and the like; sorbitan alkyl esters such as sorbitan monolaurate, sorbitan monopalmitate, sorbitan monostearate and the like; polyoxyethylene sorbitan alkyl esters such as polyoxyethylene sorbitol laurate, polyoxyethylene sorbitol oleate laurate and the like; polyoxyalkylenes such as polyoxyethylene, polyoxypropylene and the like; and polyoxyethylene alkylamides.

The amount of the non-ionic surfactant added is 0.05-10 parts by weight, preferably 0.5-3 parts by weight per 100 parts by weight (solid content) of the aqueous acrylic resin emulsion type pressure-sensitive adhesive. When the amount of the surfactant is less than 0.05 part by weight, the bleeding-out of the surfactant onto the surface of the pressure-sensitive adhesive layer is insufficient, making small the reduction in adhesion strength. That is, the initial adhesion strength of the pressure-sensitive adhesive tape is more than 450 g/25 mm, which is not preferable. When the amount of the surfactant is more than 10 parts by weight, the pressure-sensitive adhesive tape has an extremely small adhesion strength, is peeled during the grinding of the back side of a semiconductor wafer, and is unable to exhibit a sufficient protective function.

Examples of the epoxy type crosslinking agent used in the present invention are water-soluble epoxy resins reactive with carboxylic acids, such as sorbitol polyglycidyl ether, polyglycol polyglycidyl ether, pentaerythritol polyglycidyl ether, trimethylolpropane polyglycidyl ether and the like.

As the aziridine type crosslinking agent used in the present invention, there can be mentioned aziridine compounds reactive with carboxylic acids, such as tetramethylol tri-$\beta$-aziridinylpropionate, trimethylolpropane $\beta$-aziridinylpropionate, trimethylolpropane tri-$\beta$-(2-methylaziridine)propionate and the like.

The epoxy type crosslinking agent and the aziridine type crosslinking agent may be used alone, but their mixed use is preferable in order to obtain a low initial adhesion strength and prevent an increase in adhesion strength with time. Their mixing proportions are preferably 1 weight part for epoxy type crosslinking agent and 0.1-10 parts by weight for aziridine type crosslinking agent in order to achieve the object of the present invention.

These crosslinking agents are added to the aqueous acrylic resin emulsion type pressure-sensitive adhesive, by itself when they are water-soluble and after dissolving in a small amount of an organic solvent

EP 0 530 729 A1

(e.g. alcohol, acetone) when they are water-insoluble.

The amount of the crosslinking agent added is ordinarily 0.01-10 parts by weight, preferably 0.05-5 parts by weight per 100 parts by weight (solid content) of the aqueous acrylic resin emulsion type pressure-sensitive adhesive. The amount of the crosslinking agent can be appropriately determined in the above range depending upon the type of crosslinking agent used, the adhesion strength required, etc. When the amount of the crosslinking agent is less than 0.01 part by weight, the acrylic resin makes no sufficient crosslinking, and the resulting pressure-sensitive adhesive tape has an initial adhesion strength to mirror wafer, of more than 450 g/25 mm and shows a large increase in adhesion strength with time. When the amount is more than 10 parts by weight, the crosslinking degree of the acrylic resin is too high; and the resulting tape has an adhesion strength of less than 50 g/25 mm, makes no sufficient adhesion to the surface of a semiconductor wafer, and is unable to fulfill an intended purpose.

As the water-soluble organic compound having a boiling point of 100°C or higher, used in the present invention, there can be mentioned, for example, cellosolve type compounds such as ethylene glycol monomethyl ether, ethylene glycol monoethyl ether, ethylene glycol diethyl ether, ethylene glycol isopropyl ether, ethylene glycol monobutyl ether and the like; carbitol type compounds such as diethylene glycol monomethyl ether, diethylene glycol monoethyl ether, diethylene glycol monobutyl ether and the like; glycosolve type compounds such as triethylene glycol monomethyl ether, triethylene glycol monoethyl ether and the like; acetate type compounds such as ethylene glycol monomethyl ether acetate, ethylene glycol monoethyl ether acetate, diethylene glycol monobutyl ether acetate and the like; and glycol type compounds such as diethylene glycol, triethylene glycol, dipropylene glycol and the like. Among these, preferable are water-soluble organic compounds each having a boiling point of 130°C or higher.

The amount of the water-soluble organic compound can be appropriately determined in view of the adhesion strength of the resulting pressure-sensitive adhesive tape to the semiconductor wafer used, but is preferably 0.1-100 parts by weight, more preferably 1-50 parts by weight per 100 parts by weight (solid content) of the aqueous acrylic resin emulsion type pressure-sensitive adhesive. When the amount is less than 0.1 part by weight, the resulting pressure-sensitive adhesive mixture has poor coatability on a base film. When the amount is more than 100 parts by weight, the resulting pressure-sensitive adhesive tape has too low an adhesion strength.

The reasons why the pressure-sensitive adhesive mixture used in the present invention has such excellent properties, are not certain. However, the reasons are presumed as follows. The use of the crosslinking agent brings about a pressure-sensitive adhesive of high molecular weight and high cohesive strength; the bleeding-out of the surfactant onto the surface of the pressure-sensitive adhesive layer results in formation of a barrier layer between the adhesive layer and the semiconductor wafer to be attached; thus, the synergistic effect by the crosslinking agent and the surfactant gives a low initial adhesion strength and substantially no increase in adhesion strength with time.

The method for coating the aqueous acrylic resin emulsion type adhesive mixture on a base film is not critical, and various known methods can be employed. Examples of the known methods are those using a reverse roll coater, a gravure coater, a bar coater, a die coater, a comma coater, etc.

Ordinarily, the aqueous acrylic resin emulsion type adhesive mixture having the above-mentioned composition is coated, by the above method, on one side of a base film, preferably a side of said film to which a corona discharge treatment has been applied, at about room temperature, followed by drying using hot air of 80-150°C, whereby a pressure-sensitive adhesive layer is formed. The thickness of the adhesive layer after drying is ordinarily about 1-100 $\mu$m.

As a release layer on the pressure-sensitive adhesive layer, there is used a synthetic resin film, preferably a polypropylene film having good releasability. A biaxially oriented polypropylene film is particularly preferable because it has good workability in attachment, peeling, etc.

In actually using the pressure-sensitive adhesive tape of the present invention, the release film is peeled off from the pressure-sensitive adhesive layer; the resulting tape is attached to the side of a semiconductor wafer in which an integrated circuit has been formed; the attached tape is trimmed mechanically or manually so as to fit the shape of the semiconductor wafer.

Description is then made on the method for attaching the pressure-sensitive adhesive tape of the present invention to the front side of a semiconductor wafer and grinding the back side of the semiconductor wafer.

An integrated circuit is formed on the surface of a mirror wafer to obtain a semiconductor wafer; the pressure-sensitive adhesive tape of the present invention is attached to the front side of the semiconductor wafer so that the pressure-sensitive adhesive layer of the tape contacts with said side of the wafer; the tape is then trimmed mechanically or manually so as to fit the shape of the wafer.

6

Thereafter, the back side of the semiconductor wafer having the pressure-sensitive adhesive tape on the front side is ground to a thickness of about 100-600 $\mu$m, using a grinding machine, for example, In-Feed Surface Grinder DFG-821F/8 manufactured by Disco Corporation.

The grindstone used in the above grinding, preferably has a grain size of # 100-1,000 at the initial rough grinding and # 700-3,000 at the final finishing grinding. The grain diameter is preferably 10-150 $\mu$m at the initial rough grinding and 1-30 $\mu$m at the final finishing grinding.

The circumferential speed of the grindstone is preferably 10-100 m/sec at the initial rough grinding and 15-120 m/sec at the final finishing grinding.

The shifting speed of the grindstone is preferably 2-10 $\mu$m/sec at the initial rough grinding and 0.1-2 $\mu$m/sec at the final finishing grinding. The grinding time is preferably 1-20 minutes in view of the grinding efficiency, etc.

During the grinding, the pressure-sensitive adhesive tape attached to the front side of the semiconductor wafer prevents the breakage of semiconductor wafer and the adhesion of grinding refuse, etc. to integrated circuit.

After the grinding is over, the grinding refuse, etc. remaining on the ground surface is washed away with pure water. Then, the pressure-sensitive adhesive tape is peeled off from the front side of the semiconductor wafer, and the front side of the wafer is washed with pure water. Thereafter, the wafer is dried.

The present invention is hereinafter described in more detail in reference to the Examples. However, the present invention is by no means restricted to the Examples. In the Examples, adhesion strength to mirror wafer and peelability from the front side of semiconductor wafer were evaluated in accordance with the following methods.

(1) Evaluation of adhesion strength

A sample tape of 25 mm in width is attached to the surface of a silicon mirror wafer using a rubber roller of 2 kg/cm$^2$. The tape-attached wafer is allowed to stand in an atmosphere of 23°C (temperature) and 50% (relative humidity) for a given period of time. Then, the sample tape is peeled off from the surface of the silicon mirror wafer using a TENSILON type tensile tester produced by Toyo Baldwin Co., Ltd., under the conditions of 23°C (temperature), 180° (peeling angle) and 30 cm/min (peeling speed), and the adhesion strength shown in the peeling is measured.

(2) Evaluation of peelability

A pressure-sensitive adhesive tape is attached to the front side of a 4-inch (101 mm) semiconductor wafer using an automatic tape-attaching machine (ATM-1000B manufactured by Takatori K.K.). The resulting wafer is allowed to stand for one day or ten days at room temperature in a cassette.

After the standing of one day or ten days, the wafer is taken out of the cassette and is ground at the back side using a grinding machine (In-Feed Surface Grinder DFG-821F/8 manufactured by Disco Corporation).

In the grinding, there are used, for initial rough grinding, a grindstone having a grain size of #320 and a grain diameter of 40-60 $\mu$m and, for final finishing grinding, a grindstone having a grain size of #1400 and a grain diameter of 5-12 $\mu$m. The circumferential speed of the grindstone is 50 m/sec in initial rough grinding and 57 m/sec in final finishing grinding. The shifting speed of the grindstone is 6 to 3 $\mu$m/sec in initial rough grinding and 1.0 to 0.5 $\mu$m/sec in final finishing grinding. The grinding time is 7 minutes and the grinding amount is about 450 $\mu$m in thickness.

After the grinding is over, the grinding refuse, etc. remaining on the ground surface are washed away with pure water. Then, the pressure-sensitive adhesive tape is peeled from the front side of the 4-inch (101 mm) semiconductor wafer using an automatic tape-releasing machine (ATRM-2000B manufactured by Takatori K.K.) by the action of Scotch Tape (trade name, a product of 3M Co.) fitted to said machine. This peeling test is conducted on 20 sheets of the semiconductor wafers each of the above size.

(a) Number of wafers having low peelability

There is examined the number of such wafers as the pressure-sensitive adhesive tape cannot be peeled from the front side of wafer. The number is taken as "number of wafers having low peelability".

(b) Number of wafers broken

Of the total 20 sheets of 4-inch (101 mm) wafers used for peelability evaluation, the wafers which have allowed for tape peeling, are examined for breakage caused by peeling, and the number of wafers broken during peeling is recorded.

Example 1

150 parts by weight of deionized water and 1.0 part by weight of a polyoxyethylene nonyl phenyl ether (a surfactant) were placed in a flask equipped with a thermometer, a reflux condenser, a dropping funnel, a nitrogen inlet and a stirrer, and heated to 70°C in a nitrogen atmosphere with stirring. Then, 0.5 part by weight of a polymerization initiator was dissolved therein.

Thereto was dropwise added, continuously in 4 hours, 100 parts by weight of a monomer mixture consisting of 23 parts by weight of methyl methacrylate, 73 parts by weight of 2-ethylhexyl acrylate, 2 parts by weight of glycidyl methacrylate and 2 parts by weight of methacrylic acid. After the dropwise addition was over, stirring was continued for 3 hours to conduct a polymerization reaction to obtain an aqueous acrylic resin emulsion type pressure-sensitive adhesive having a solid content of about 47% by weight.

To 100 parts by weight (solid content) of the above adhesive were added 10 parts by weight of diethylene glycol monobutyl ether as a water-soluble organic compound, 0.5 part by weight of polyoxyethylene nonyl phenyl ether as a surfactant and, as a crosslinking agent, 0.5 part by weight of trimethylolpropane polyglycidyl ether and 0.5 part by weight of tetramethylol tri-$\beta$-aziridinylpropionate, to prepare a pressure-sensitive adhesive mixture.

There was used, as a base film, a di-layered film of 110 $\mu$m in thickness, consisting of an EVA film and a PP film, which was manufactured by a T-die method. The surface of the EVA layer of the base film was subjected to a corona discharge treatment.

The above adhesive mixture was coated on the corona-discharge-treated surface of the above base film using a roll coater and dried at 90°C to obtain a pressure-sensitive adhesive tape having a pressure-sensitive adhesive layer of 10 $\mu$m in thickness.

The tape was attached to the front side of a 4-inch (101 mm) semiconductor wafer by the above-mentioned method. The resulting wafer was allowed to stand for one day or ten days in a cassette. After the standing of one day or ten days, the back side of the wafer was ground by the above-mentioned method. After the grinding, the tape was peeled off from the front side of the wafer by the above-mentioned method.

The above peeling test was conducted on 20 sheets of semiconductor wafers each of the above size, and there were counted the number of wafers having low peelability and the number of wafers broken when each wafer was subjected to the peeling test.

As a result, there was neither wafer having low peelability, nor wafer broken. The results are shown in Table 1.

Also, the above pressure-sensitive adhesive tape was measured for adhesion strength to mirror wafer by the above-mentioned method, right after attaching to the wafer, after standing of one day and after standing of 10 days. The results are shown in Table 1.

As is clear from Table 1, the initial adhesion strength was 180 g/25 mm, the adhesion strength after standing of one day was 200 g/25 mm, and the adhesion strength after standing of ten days was 250 g/25 mm; thus, the initial adhesion strength was low and the increase in adhesion strength with time was small.

Example 2

To 100 parts by weight (solid content) of the same aqueous acrylic resin emulsion type pressure-sensitive adhesive as used in Example 1 were added 10 parts by weight of triethylene glycol monomethyl ether as a water-soluble organic compound and 1 part by weight of polyglycol polyglycidyl ether as a crosslinking agent, to prepare a pressure-sensitive adhesive mixture.

There was used, as a base film, an EVA film of 150 $\mu$m in thickness, which was produced by a T-die method. One side of the base film was subjected to a corona discharge treatment.

The above adhesive mixture was coated on the corona-discharge-treated side of the base film using a roll coater, and dried at 100°C to obtain a pressure-sensitive adhesive tape having a pressure-sensitive adhesive layer of 20 $\mu$m in thickness.

The tape was subjected to the same tests as in Example 1. The initial adhesion strength was low and the increase in adhesion strength with time was small. Further, there was neither wafer having low peelability, nor wafer broken. The results are shown in Table 1.

Example 3

To 100 parts by weight (solid content) of the same aqueous acrylic resin emulsion type pressure-sensitive adhesive as used in Example 1 were added 10 parts by weight of diethylene glycol monobutyl ether as a water-soluble organic compound and 0.3 part by weight of tetramethylol tri-$\beta$-aziridinylpropionate as a crosslinking agent, to prepare a pressure-sensitive adhesive mixture.

There was used, as a base film, a PB film of 150 $\mu$m in thickness, which was produced by a T-die method. One side of the base film was subjected to a corona discharge treatment.

The above adhesive mixture was coated on the corona-discharge-treated side of the base film using a roll coater, and dried at 100°C to obtain a pressure-sensitive adhesive tape having a pressure-sensitive adhesive layer of 40 $\mu$m in thickness.

The tape was subjected to the same tests as in Example 1. The initial adhesion strength was low and the increase in adhesion strength with time was small. Further, there was neither wafer having no peelability, nor wafer broken. The results are shown in Table 1.

Comparative Example 1

The same monomer mixture as used in Example 1 was dissolved in acetone and polymerized to obtain an acrylic resin solution type pressure-sensitive adhesive having a solid content of 50% by weight. The adhesive was coated on the same base film as used in Example 1, and dried to obtain a pressure-sensitive adhesive tape having a pressure-sensitive adhesive layer of 10 $\mu$m in thickness.

The tape was subjected to the same tests as in Example 1. The results are shown in Table 1. As shown in Table 1, the adhesion strength increased from 710 g/25 mm (initial) to 1000 g/25 mm after one-day standing and to 1300 g/25 mm after ten-day standing. Further, some wafers allowed no tape peeling and there was wafer breakage during peeling.

Comparative Example 2

A pressure-sensitive adhesive tape was obtained in the same manner as in Comparative Example 1 except that the same crosslinking agents as used in Example 1 were added to 100 parts by weight (solid content) of the same pressure-sensitive adhesive as used in Comparative Example 1, each in the same amount as in Example 1.

The tape was subjected to the same tests as in Example 1. The results are shown in Table 1. As shown in Table 1, the adhesion strength increased from 490 g/25 mm (initial) to 600 g/25 mm after one-day standing and to 1000 g/25 mm after ten-day standing. Further, some wafers allowed no tape peeling and there was wafer breakage during peeling.

Comparative Example 3

A pressure-sensitive adhesive tape was obtained in the same manner as in Example 1 except that no crosslinking agent was added. The tape was subjected to the same tests as in Example 1. The results are shown in Table 1. As shown in Table 1, the tape had a high initial adhesion strength and showed an increase in adhesion strength with time. Further, some wafers allowed no tape peeling and there was wafer breakage during peeling.

Comparative Example 4

A pressure-sensitive adhesive tape was obtained in the same manner as in Example 1 except that the crosslinking agents were used in different amounts, i.e. 10 parts by weight of trimethylolpropane polyglycidyl ether and 10 parts by weight of tetramethylol tri-$\beta$-aziridinylpropionate. The tape was subjected to the same tests as in Example 1. The results are shown in Table 1. As shown in Table 1, the tape had a low initial adhesion strength of 5 g/25 mm and could not be attached to a 4-inch (101 mm) semiconductor wafer.

Comparative Example 5

A pressure-sensitive adhesive tape was obtained in the same manner as in Example 1 except that the crosslinking agents were used in different amounts, i.e. 0.003 parts by weight of trimethylolpropane polyglycidyl ether and 0.002 parts by weight of tetramethylol tri-$\beta$-aziridinylpropionate. The tape was subjected to the same tests as in Example 1. The results are shown in Table 1. As shown in Table 1, the tape had a high initial adhesion strength and showed a viscosity increase with time. Further, some wafers allowed no tape peeling and there was wafer breakage during peeling.

Comparative Example 6

A pressure-sensitive adhesive tape was obtained in the same manner as in Example 1 except that the non-ionic surfactant was added in an amount of 0.04 parts by weight at the time of monomer mixture polymerization. The tape was subjected to the same tests as in Example 1. The results are shown in Table 1. As shown in Table 1, the tape had a high initial adhesion strength and showed an increase in adhesion strength with time. Further, some wafers allowed no tape peeling and there was wafer breakage during peeling.

Comparative Example 7

A pressure-sensitive adhesive tape was obtained in the same manner as in Example 1 except that the non-ionic surfactant was added in an amount of 19 parts by weight after the completion of the polymerization reaction. The tape was subjected to the same tests as in Example 1. The results are shown in Table 1. As shown in Table 1, the tape had a low initial adhesion strength of 20 g/25 mm and could not be attached to a 4-inch (101 mm) semiconductor wafer.

Comparative Example 8

A pressure-sensitive adhesive tape was obtained in the same manner as in Example 1 except that no water-soluble organic compound (diethylene glycol monobutyl ether) was added. The tape was subjected to the same tests as in Example 1. The results are shown in Table 1. As shown in Table 1, the tape had a high initial adhesion strength and showed an increase in adhesion strength with time. Further, some wafers allowed no tape peeling and there was wafer breakage during peeling.

Table 1

| | | Adhesion strength (g/25 mm width) | | | Tape peelability*1 | | | |
| | | Right after attaching | After standing of one day | After standing of ten days | After standing of one day | | After standing of ten days | |
| | | | | | Number of wafers having low peelability | Number of wafers broken | Number of wafers having low peelability | Number of wafers broken |
| Example | 1 | 60 | 80 | 120 | 0/20 | 0/20 | 0/20 | 0/20 |
| | 2 | 180 | 200 | 250 | 0/20 | 0/20 | 0/20 | 0/20 |
| | 3 | 200 | 230 | 300 | 0/20 | 0/20 | 0/20 | 0/20 |
| Comparative Example | 1 | 710 | 1000 | 1300 | 11/20 | 7/9 | 15/20 | 5/5 |
| | 2 | 490 | 600 | 1000 | 2/20 | 10/18 | 13/20 | 5/7 |
| | 3 | 630 | 930 | 1300 | 6/20 | 10/14 | 15/20 | 5/5 |
| | 4 | 5 | - | - | - | - | - | - |
| | 5 | 510 | 800 | 1200 | 7/20 | 9/13 | 14/20 | 6/6 |
| | 6 | 480 | 580 | 800 | 2/20 | 9/18 | 7/20 | 9/13 |
| | 7 | 20 | - | - | - | - | - | - |
| | 8 | 500 | 660 | 930 | 3/20 | 8/17 | 8/20 | 8/12 |

*1 Denominator indicates the total number of wafers tested.
Numerator indicates the number of wafers having low
peelability or the number of wafers broken.

According to the present invention there is provided a pressure-sensitive adhesive tape used in grinding the back side of a semiconductor wafer, having a low initial adhesion strength to mirror wafer and showing a small increase in adhesion strength with time. There is also provided a method for grinding the back side of a semiconductor wafer, which comprises attaching the above adhesive tape to the front side of the wafer and conducting said grinding.

11

When the above adhesive tape is attached to the front side of a semiconductor wafer and the back side of the wafer is ground, there is no wafer breakage during grinding; the tape can be easily peeled from the wafer even after about ten days from tape application to wafer; there is no wafer breakage during peeling; thus, grinding operation can be improved significantly.

**Claims**

1. A method for grinding the back side of a semiconductor wafer, which comprises attaching a pressure-sensitive adhesive tape to the front side of the semiconductor wafer on which an integrated circuit has been formed and then grinding the back side of the semiconductor wafer, said pressure-sensitive adhesive tape comprising a single-layered or multi-layered synthetic resin film as a base film and a pressure-sensitive adhesive layer formed thereon, having an adhesion strength to mirror wafer, of 50-450 g/25 mm at 23°C, said pressure-sensitive adhesive tape being obtained by coating to one side of said base film, an aqueous acrylic resin emulsion type pressure-sensitive adhesive mixture comprising 100 parts by weight (as solid content) of an aqueous acrylic resin emulsion type pressure-sensitive adhesive, 0.05-10 parts by weight of a non-ionic surfactant, 0.01-10 parts by weight of a crosslinking agent selected from the group consisting of an epoxy type crosslinking agent, an aziridine type crosslinking agent and a mixture of the above two and 0.1-100 parts by weight of a water-soluble organic compound having a boiling point of 100°C or higher, and then drying the coated pressure-sensitive adhesive mixture on said side of said base film.

2. A method according to Claim 1, wherein the crosslinking agent is a mixture of an aziridine type crosslinking agent and an epoxy type crosslinking agent.

3. A method according to Claim 2, wherein the mixing proportions of the crosslinking agents are 1 part by weight for the epoxy type crosslinking agent and 0.1-10 parts by weight of the aziridine type crosslinking agent.

4. A pressure-sensitive adhesive tape used in grinding the back side of a semiconductor wafer, which comprises a single-layered or multi-layered synthetic resin film as a base film and a pressure-sensitive adhesive layer formed thereon, having an adhesion strength to mirror wafer, of 50-450 g/25 mm at 23°C, and which is obtained by coating to one side of said base film, an aqueous acrylic resin emulsion type pressure-sensitive adhesive mixture comprising 100 parts by weight (as solid content) of an aqueous acrylic resin emulsion type pressure-sensitive adhesive, 0.05-10 parts by weight of a non-ionic surfactant, 0.01-10 parts by weight of a crosslinking agent selected from the group consisting of an epoxy type crosslinking agent, an aziridine type crosslinking agent and a mixture of the above two and 0.1-100 parts by weight of a water-soluble organic compound having a boiling point of 100°C or higher, and then drying the coated pressure-sensitive adhesive mixture on said side of said base film.

5. A pressure-sensitive adhesive tape according to Claim 4, wherein the crosslinking agent is a mixture of an aziridine type crosslinking agent and an epoxy type crosslinking agent.

6. A pressure-sensitive adhesive tape according to Claim 5, wherein the mixing proportions of the crosslinking agents are 1 part by weight for the epoxy type crosslinking agent and 0.1-10 parts by weight of the aziridine type crosslinking agent.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| Y | EP-A-0 185 767 (MITSUI TOATSU CHEMICALS)<br>* page 1, paragraph 1 *<br>* page 7, line 26 - page 8, line 4 *<br>* page 9, line 1 - line 11 *<br>* page 9, line 17 - page 10, line 22 *<br>* page 16, line 20 - line 25; claims * | 1,4 | H01L21/302<br>C09J7/02<br>C09J133/06 |
| D | & JP-B-1 051 511 (...) | | |
| Y | US-A-4 983 656 (TOSHIYUKI ITO)<br>* abstract; claims * | 1,4 | |
| A | EP-A-0 252 739 (FSK KABUSHIKI KAISHA)<br>* claims 1-4; example 1 * | 1,4 | |
| A | DE-C-3 901 690 (LOHMANN GMBH & CO KG) | | |

TECHNICAL FIELDS
SEARCHED (Int. Cl.5 )

H01L
C09J

The present search report has been drawn up for all claims

| Place of search | Date of completion of the search | Examiner |
|---|---|---|
| THE HAGUE | 09 DECEMBER 1992 | GIRARD Y.A. |

EPO FORM 1503 03.82 (P0401)